(19)

**Europäisches Patentamt**
**European Patent Office**
**Office européen des brevets**

(11) **EP 4 592 694 A1**

(12) **EUROPEAN PATENT APPLICATION**
published in accordance with Art. 153(4) EPC

(43) Date of publication:
30.07.2025 Bulletin 2025/31

(21) Application number: 23889033.9

(22) Date of filing: 02.11.2023

(51) International Patent Classification (IPC):
*G01R 31/367* (2019.01)    *G01R 31/371* (2019.01)
*G01R 31/396* (2019.01)    *G01R 31/3842* (2019.01)
*G01R 19/165* (2006.01)

(52) Cooperative Patent Classification (CPC):
G01R 19/165; G01R 31/367; G01R 31/371;
G01R 31/3842; G01R 31/396

(86) International application number:
PCT/KR2023/017347

(87) International publication number:
WO 2024/101771 (16.05.2024 Gazette 2024/20)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 09.11.2022 KR 20220149084
31.10.2023 KR 20230148282

(71) Applicant: LG Energy Solution, Ltd.
Seoul 07335 (KR)

(72) Inventors:
• KIM, Young Min
  Daejeon 34122 (KR)
• LEE, Sun Jong
  Daejeon 34122 (KR)
• SUNG, Yong Chul
  Daejeon 34122 (KR)

(74) Representative: Plasseraud IP
104 Rue de Richelieu
CS92104
75080 Paris Cedex 02 (FR)

(54) **DEVICE AND METHOD FOR DIAGNOSING PERFORMANCE OF BATTERY**

(57)    A battery performance diagnosis apparatus according to an embodiment disclosed herein includes a diagnosis module, a diagnosis controller configured to generate a generation command instructing generation of a first channel diagnosis module for a first channel among a plurality of channels of a charger/discharger, based on the diagnosis module, when a battery is inserted into the first channel, and an interface module configured to copy the diagnosis module and load the first channel diagnosis module, based on the generation command, in which the first channel diagnosis module may be configured to, by executing at least one diagnosis function among one or more diagnosis functions, obtain measurement information regarding the battery in real time, diagnose performance of the battery and obtain a diagnosis result, and return the diagnosis result to the diagnosis controller, through the interface module.

FIG.1A

EP 4 592 694 A1

**Description**

**[TECHNICAL FIELD]**

CROSS-REFERENCE TO RELATED APPLICATION

This application claims priority to and the benefit of Korean Patent Application No. 10-2022-0149084 filed in the Korean Intellectual Property Office on November 9, 2022, and Korean Patent Application No. 10-2023-0148282 filed in the Korean Intellectual Property Office on October 31, 2023, the entire contents of which are incorporated herein by reference.

TECHNICAL FIELD

Embodiments disclosed herein relate to a battery performance diagnosis apparatus and method.

**[BACKGROUND ART]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

As industrial fields using batteries expand, battery management systems (BMSs) diagnosing safety of batteries are also developing. The BMSs, which are systems for diagnosing performance of the batteries, may diagnose performance of the batteries, such as over-voltage, battery cell failures, temperature sensor failures, short-circuits, etc., based on measurement information, such as voltages, currents, temperatures, etc., of the batteries, measured by chargers/dischargers.

As performance of batteries is improved with the development of the battery industry field, various diagnosis algorithms have been generated.

**[DISCLOSURE]**

**[TECHNICAL PROBLEM]**

However, to execute newly generated diagnosis algorithms, a separate infrastructure is required. In this context where various diagnosis algorithms for diagnosing battery performance are developed, it is necessary to secure a platform capable of battery performance by operating with a charger/discharger without establishment of a separate infrastructure.

Moreover, as batteries with poor performance may result in explosion of the batteries, it is necessary to automate control for pausing or terminating charging or discharging of the batteries by determining that a diagnosis result may lead to explosion.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery performance diagnosis apparatus according to an embodiment disclosed herein includes a diagnosis module, a diagnosis controller configured to generate a generation command instructing generation of a first channel diagnosis module for a first channel among a plurality of channels of a charger/discharger, based on the diagnosis module, when a battery is inserted into the first channel, and an interface module configured to copy the diagnosis module and load the first channel diagnosis module, based on the generation command, in which the first channel diagnosis module includes an information obtaining module configured to obtain measurement information regarding the battery in real time through the interface module, during charging or discharging of the battery by using the charger/discharger, a diagnosis function executing module configured to, by executing at least one diagnosis function among one or more diagnosis functions, diagnose performance of the battery based on the measurement information and obtain a diagnosis result with respect to the at least one diagnosis function, and a returning module configured to return the diagnosis result to the diagnosis controller, through the interface module, in which the diagnosis controller is further configured to store the diagnosis result and generate a termination command instructing termination of the first channel diagnosis module, when charging or discharging of the battery is completed.

In an embodiment, the battery performance diagnosis apparatus may further include a transmitting unit configured to transmit the diagnosis result to a manager terminal.

In an embodiment, the battery performance diagnosis apparatus may further include a charging/discharging controller configured to control the charger/discharger to pause or terminate charging or discharging of the battery, when the diagnosis result indicates designated abnormality of the battery or the charger/discharger.

In an embodiment, the transmitting unit may be further configured to transmit a charging/discharging control result regarding the pause or termination to the manger terminal, when charging or discharging is paused or terminated.

In an embodiment, the battery performance diagnosis apparatus may further include a version checking module loaded to a memory by the interface module to compare a version of the diagnosis module with a version of the first channel diagnosis module, based on a version check command generated by the diagnosis controller.

In an embodiment, the diagnosis function executing module is further configured to generate a diagnosis result indicating abnormality of the battery or abnormality of the charger/discharger when a measured current of the battery does not decrease for a preset time or more in a constant voltage charging period of the battery, as a first diagnosis function among the one or more diagnosis functions.

In an embodiment, the first channel diagnosis module may further include a pre-processing module configured to convert the measurement information into a command corresponding to each of the one or more diagnosis functions, and the diagnosis function executing module may be further configured to execute each of the one or more diagnosis functions based on the converted command.

A battery performance diagnosis method according to an embodiment disclosed herein includes a diagnosis control operation of generating a generation command instructing generation of a first channel diagnosis module for a first channel among a plurality of channels of a charger/discharger, based on a diagnosis module including one or more diagnosis functions, when a battery is inserted into the first channel, an interface operation of loading the first channel diagnosis module, based on the generation command, and an operation of diagnosing performance of the battery based on the first channel diagnosis module, in which the diagnosing of the performance of the battery includes an information obtaining operation of obtaining measurement information regarding the battery in real time, during charging or discharging of the battery by using the charger/discharger, a diagnosis function executing operation of diagnosing the battery based on the measurement information by executing at least one diagnosis function among the one or more diagnosis functions, an operation of obtaining a diagnosis result with respect to the at least one diagnosis function among the one or more diagnosis functions, and an operation of storing the diagnosis result, in which a termination command instructing termination of the first channel diagnosis module is generated, when charging or discharging of the battery is completed.

In an embodiment, the battery performance diagnosis method may further include an operation of transmitting the diagnosis result to a manager terminal.

In an embodiment, the battery performance diagnosis method may further include a charging/discharging control operation of performing control to pause or terminate charging or discharging of the battery, when the diagnosis result indicates designated abnormality of the battery or the charger/discharger.

In an embodiment, the battery performance diagnosis method may further include an operation of transmitting a charging/discharging control result regarding the pause or termination to the manger terminal, when charging or discharging is paused or terminated.

In an embodiment, the battery performance diagnosis method may further include an operation of generating a version check command, an operation of loading a version check module into a memory based on the version check command, and an operation of comparing a version of the diagnosis module with a version of the first channel diagnosis module, by using the version check module.

In an embodiment, the diagnosis function executing operation may include an operation of obtaining a diagnosis result indicating abnormality of the battery or abnormality of the charger/discharger when a measured current of the battery does not decrease for a preset time or more in a constant voltage charging period of the battery, as a first diagnosis function among the one or more diagnosis functions.

In an embodiment, the battery performance diagnosis method may further include a pre-processing operation of converting the measurement information into a command corresponding to each of the one or more diagnosis functions, in which the diagnosis function executing operation is performed for the one or more diagnosis functions based on the converted command.

## [ADVANTAGEOUS EFFECTS]

The battery performance diagnosis apparatus according to an embodiment disclosed herein may generate various diagnosis results in real time without establishment of a separate infrastructure, by linking at least one diagnosis dynamic linking library (DLL) file using the diagnosis DLL file.

The battery performance diagnosis apparatus according to an embodiment disclosed herein may automatically prevent a dangerous situation likely to lead to battery explosion, by pausing or terminating charging or discharging of the battery, when a diagnosis result with respect to abnormality of the battery and/or abnormality of the charger/discharger indicates designated abnormality.

The effects of the battery performance analysis apparatus according to the disclosure of the present document are not limited to the effects mentioned above, and other effects not mentioned will be clearly understood by those of ordinary skill in the art according to the disclosure of the present document.

**[DESCRIPTION OF DRAWINGS]**

FIGS. 1A and 1B schematically show a battery performance diagnosis system according to various embodiments disclosed herein.

FIG. 2 is a block diagram showing a battery performance diagnosis apparatus according to an embodiment disclosed herein.

FIG. 3 is a graph showing a voltage and a current of a battery over time according to an embodiment disclosed herein.

FIG. 4A shows a battery including a short-circuited battery cell according to an embodiment disclosed herein.

FIG. 4B is a graph showing a diagnosis result according to an embodiment disclosed herein.

FIG. 5A is a flowchart of a battery performance diagnosis method according to an embodiment disclosed herein.

FIG. 5B is a flowchart of a method for executing a diagnosis function according to an embodiment disclosed herein.

FIG. 5C is a flowchart of a method for executing a diagnosis function according to an embodiment disclosed herein.

FIG. 5D is a flowchart of a method for executing a diagnosis function according to an embodiment disclosed herein.

With regard to the description of the drawings, similar reference numerals may be used to refer to similar or related components.

**[MODE FOR INVENTION]**

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g.,

modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

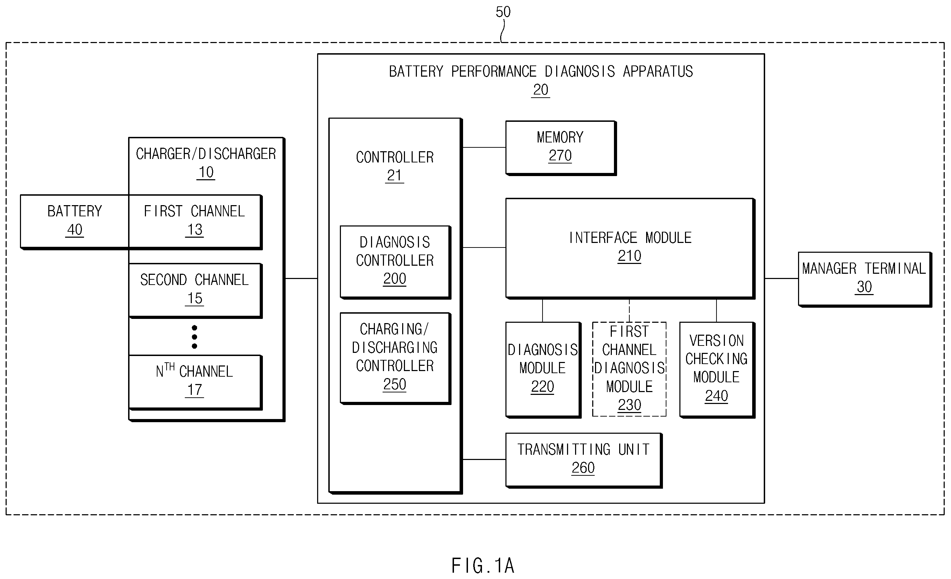

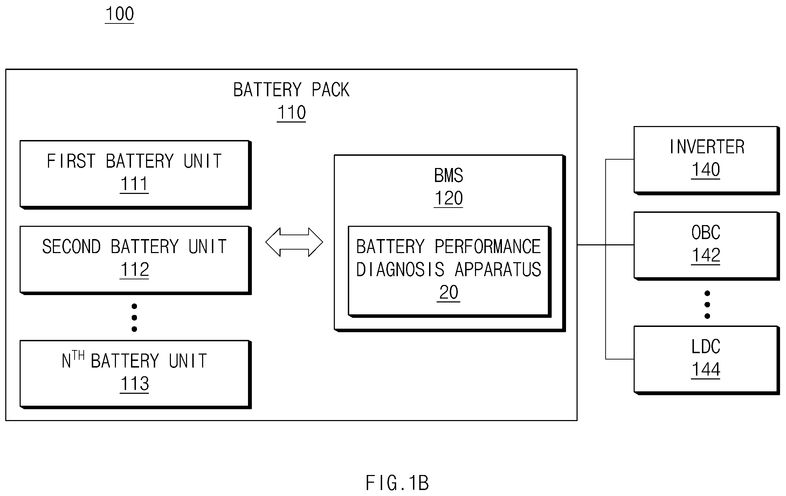

FIGS. 1A and 1B schematically show a battery performance diagnosis system 50 according to various embodiments disclosed herein.

Referring to FIG. 1A, the battery performance diagnosis system 50 may include a charger/discharger 10, a battery performance diagnosis apparatus 20, a manager terminal 30, and a battery 40.

The charger/discharger 10 may include n channels 13, 15, and 17. Herein, the charger/discharger 10 may be a device capable of executing a charging function and/or a discharging function. Meanwhile, according to an embodiment, the charger/discharger 10 may be replaced with a charger that performs the charging function or a discharger that performs the discharging function. The battery 40 may be inserted into each of the n channels 13, 15, and 17. The n channels 13, 15, and 17 may include slots into which the battery 40 is inserted, and a wire connecting the slots to the charger/discharger 10. Herein, n is an integer number of 2 or greater. The n channels 13, 15, and 17 may also be referred to as a plurality of channels 13, 15, and 17 below.

The battery 40 may be a chargeable secondary battery. The battery 40 may include a battery pack. Herein, the battery pack may include one or more battery modules. Each of the one or more battery modules may include one or more battery cells. Each battery cell may include a positive electrode, a negative electrode, a separator, an electrolyte, or a combination thereof. The battery cell is a basic unit of the battery 40, which may be used by charging or discharging electrical energy.

The battery performance diagnosis apparatus 20 may include a controller 21, an interface module 210, a diagnosis module 220, a version checking module 230, a transmitting unit 260, a memory 270, or a combination thereof. Herein, at least one of the interface module 210, the diagnosis module 220, or the version checking module 230 may be implemented with software.

The controller 21 may further include a diagnosis controller 200 and a charging/discharging controller 250.

The diagnosis controller 200 may generate a channel diagnosis module, check a version thereof, and execute, terminate, and remove the channel diagnosis module, by transmitting a command to the interface module 210. Hereinbelow, with reference to the drawings, generation, version check, execution, termination, and removal operations of the channel diagnosis module will be described.

Generation of Channel Diagnosis Module

The diagnosis controller 200 may load the interface module 210 into the memory 270.

The diagnosis controller 200 may generate a generation command (e.g., CreateDIAGcell()) instructing generation of the channel diagnosis module. The diagnosis controller 200 may generate a generation command for instructing generation of the channel diagnosis module, based on a signal (e.g., a signal for sensing insertion of the battery 40) from the charger/discharger 10.

The diagnosis controller 200 may generate a generation command for instructing generation of the channel diagnosis module, corresponding to a channel into which the battery 40 is inserted, among the plurality of channels 13, 15, and 17. For example, when the battery 40 is inserted into a first channel 13 among the plurality of channels 13, 15, and 17 of the charger/discharger 10, the diagnosis controller 200 may generate a generation command for instructing generation of the first channel diagnosis module 230 for the first channel 13. For example, when the battery 40 is inserted into the first channel 13 to an $n^{th}$ channel 17, the diagnosis controller 200 may generate a generation command for instructing generation of the first channel diagnosis module 230 to an $n^{th}$ diagnosis module (not shown). Hereinbelow, the battery performance diagnosis apparatus 20 will be described assuming that the battery 40 is inserted into the first channel 13.

The diagnosis controller 200 may transmit the generated generation command for instructing generation of the first channel diagnosis module 230 to the interface module 210.

The interface module 210 may generate the first channel diagnosis module 230. The interface module 210 may load the first channel diagnosis module 230 based on the generation command. The interface module 210 may generate the first channel diagnosis module 230, based on the generation command for instructing generation of the first channel diagnosis module 230. Upon receiving the generation command for instructing generation of the first channel diagnosis module 230, the interface module 210 may generate the first channel diagnosis module 230. Herein, the first channel diagnosis module 230 may be implemented as software.

The interface module 210 may generate the first channel diagnosis module 230, based on the diagnosis module 220. The interface module 210 may load the first channel diagnosis module 230, based on the diagnosis module 220. For example, the interface module 210 may copy the diagnosis module 220 and generate the first channel diagnosis module 230. Herein, the diagnosis module 220 may include an information obtaining module 222, a pre-processing module 224, a diagnosis function executing module 226, a returning module 228, or a combination thereof.

The interface module 210 may generate a response to the generation command for instructing generation of the channel diagnosis module to the diagnosis controller 200. Herein, the response may indicate a generation result of the first channel diagnosis module 230.

In an embodiment, the diagnosis controller 200 may determine an operation to be performed next, based on the response to the generation command. For example, when the response to the generation command indicates success, the diagnosis controller 200 may check a channel diagnosis module version. For example, when the response to the generation command indicates a file copy failure, the diagnosis controller 200 may terminate diagnosis of the battery 40 inserted into the first channel 13. When the response to the generation command indicates the file copy failure, the diagnosis controller 200 may store an error code indicated by the response to the generation command.

Version Check of Channel Diagnosis Module

The diagnosis controller 200 may generate a version check command (Init()) (generation condition: generation based on return of Init() or generation based on return of CreateDIAGcell()).

The interface module 210 may load the version checking module 240 into the memory 270. The interface module 210 may load the version checking module 240 into the memory 270, based on the version check command. The interface module 210 may load the version checking module 240 into the memory 270, upon receiving the version check command from the diagnosis controller 200.

The interface module 210 may convert the version check command (Init()) into a version check command (CheckVersion()) and transmit the same to the version checking module 230.

The version checking module 240 may compare a version of the diagnosis module 220 with a version of the first channel diagnosis module 230. Upon receiving the version check command (CheckVersion()) from the interface module 210, the version checking module 240 may compare the version of the diagnosis module 220 with the version of the first channel diagnosis module 230.

When the version of the diagnosis module 220 and the version of the first channel diagnosis module 230 are different from each other, the version checking module 240 may copy the diagnosis module 220 to replace the first channel diagnosis module 230.

The version checking module 240 may transmit a check result to the diagnosis controller 200. The version checking module 240 may transmit the check result to the diagnosis controller 200 through the interface module 210.

The diagnosis controller 200 may receive the check result. The diagnosis controller 200 may receive the check result through the interface module 210.

In an embodiment, the diagnosis controller 200 may determine an operation to be performed next, based on the check result. For example, when the check result indicates success, the diagnosis controller 200 may execute a channel diagnosis module. For example, when the check result indicates the file copy failure, the diagnosis controller 200 may terminate diagnosis of the battery 40 inserted into the first channel 13. When the check result indicates the file copy failure, the diagnosis controller 200 may store an error code indicated by the response to the generation command.

According to an embodiment, an operation of checking the channel diagnosis module version may be omitted. In this case, the diagnosis controller 200 may generate the channel diagnosis module and then execute the channel diagnosis module.

Execution of Channel Diagnosis Module

The diagnosis controller 200 may execute an execution command (Run()) instructing execution of the first channel diagnosis module 230. The diagnosis controller 200 may generate the execution command (Run()) based on measurement information regarding the battery 40. Herein, the measurement information may include a measurement signal and/or a state value. The measurement signal may include a voltage, a current, and/or a temperature, and the state value may include a state of health (SoH) and/or a state of charge (SoC). For example, the diagnosis controller 200 may generate the execution command (Run()) when the measurement information regarding the battery 40 is obtained from the charger/discharger 10. Herein, the execution command (Run()) may be generated repeatedly during charging/-discharging of the battery 40. For example, the execution command (Run()) may be generated each time when the measurement information regarding the battery 40 is obtained from the charger/discharger 10.

The diagnosis controller 200 may generate the execution command instructing execution of the first channel diagnosis module 230 (generation condition: generation based on return of Init() or generation based on return of CreateDIAGcell()). The diagnosis controller 200 may generate an execution command instructing execution of the first channel diagnosis module 230 based on the check result (e.g., a signal indicating that the version of the diagnosis module 220 and the version of the first channel diagnosis module 230 are the same as each other) from the version check module 240. Herein, the first channel diagnosis module 230 may be a copy of the diagnosis module 220. Herein, the diagnosis module 220 may include the information obtaining module 222, the pre-processing module 224, the diagnosis function executing module 226, the returning module 228, or a combination thereof. Likewise, the first channel diagnosis module 230 may include the information obtaining module 222, the pre-processing module 224, the diagnosis function executing module 226, the returning module 228, or a combination thereof.

The diagnosis controller 200 may transmit the generated execution command (Run()) to the interface module 210.

The interface module 210 may convert the execution command (Run()) into a diagnosis execution command (RunDiag()). The interface module 210 may transmit the converted diagnosis execution command (RunDiag()) to the first channel diagnosis module 230.

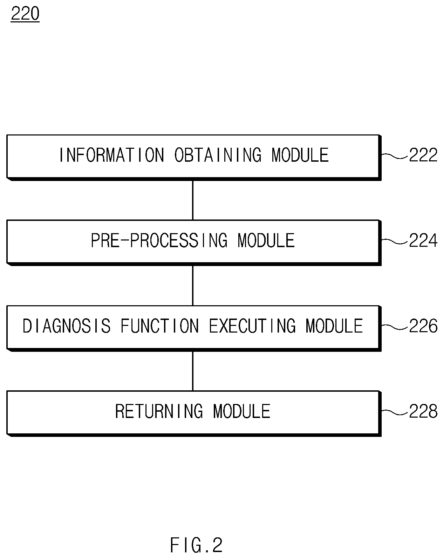

The first channel diagnosis module 230 may diagnose performance of the battery 40. The first channel diagnosis module 230 may diagnose performance of the battery 40 based on the diagnosis execution command (RunDiag()), by executing at least one diagnosis function among one or more diagnosis functions. The first channel diagnosis module 230 may execute at least one of one or more diagnosis functions, upon receiving the diagnosis execution command (RunDiag()) from the interface module 210. Herein, the diagnosis execution command (RunDiag()) may include the measurement information regarding the battery 40. Herein, the one or more diagnosis functions will be described in more detail with reference to FIG. 2 below.

More specifically, the first channel diagnosis module 230 may obtain the measurement information regarding the battery 40 through the diagnosis execution command (RunDiag()). The first channel diagnosis module 230 may diagnose performance of the battery 40 by generating and/or converting commands (e.g., DiagSMAVD(), DiagCE(), DiagCaSD(), DiagAIVE()) respectively corresponding to the one or more diagnosis functions, based on the diagnosis execution command (RunDiag()).

The first channel diagnosis module 230 may obtain a diagnosis result with respect to the performance of the battery 40 according to each of the one or more diagnosis functions through the command corresponding to each of the one or more diagnosis functions.

The first channel diagnosis module 230 may return the diagnosis result to the diagnosis controller 200. The first channel diagnosis module 230 may return the diagnosis result to the diagnosis controller 200, through the interface module 210.

The diagnosis controller 200 may perform predetermined operations based on the diagnosis result. For example, the diagnosis controller 200 may store the diagnosis result. In another example, the diagnosis controller 200 may transmit the diagnosis result to the charging/discharging controller 250 and/or the transmitting unit 260.

The charging/discharging controller 250 may perform designated operations based on the diagnosis result. For example, the charging/discharging controller 250 may determine whether the diagnosis result indicates designated abnormality. Herein, the designated abnormality may mean high-risk abnormality among abnormalities of one or more of the battery 40 and the charger/discharge 10. For example, the designated abnormality may mean abnormality likely to lead to explosion. The charging/discharging controller 250 may perform charging/discharging control to pause or terminate charging or discharging of the battery 40, when the diagnosis result indicates the designated abnormality. The charging/discharging controller 250 may transmit a charging/discharging control result to the transmitting unit 260 and/or the manager terminal 30.

Next, the transmitting unit 260 may transmit the diagnosis result to the manager terminal 30.

Termination of Channel Diagnosis Module

The diagnosis controller 200 may generate a termination command (Terminate()) terminating execution of the first channel diagnosis module 230. The diagnosis controller 200 may generate the termination command (Terminate()) terminating execution of the first channel diagnosis module 230, when charging/discharging of the battery 40 is terminated.

The diagnosis controller 200 may transmit the termination command (Terminate()) to the interface module 210.

The interface module 210 may terminate the first channel diagnosis module 230 based on the termination command (Terminate()).

The interface module 210 may generate a termination result (e.g., a response to the termination command) indicating that the first channel diagnosis module 230 is terminated. The interface module 210 may transmit the termination result to the diagnosis controller 200.

Removal of Channel Diagnosis Module

The diagnosis controller 200 may generate a deletion command (DestoryDIAGcell()) instructing deletion of the first channel diagnosis module 230. The diagnosis controller 200 may generate the deletion command based on the termination signal. The diagnosis controller 200 may generate the deletion command based on the deletion result received from the interface module 210.

The diagnosis controller 200 may transmit the deletion command to the interface module 210.

The interface module 210 may unload and/or delete the first channel diagnosis module 230 based on the deletion command. The interface module 210 may unload and/or delete the first channel diagnosis module 230 based on the deletion command received from the diagnosis controller 200.

Referring to FIG. 1B, an electric vehicle 100 including the battery performance diagnosis apparatus 20 is illustrated. The electric vehicle 100 may include a battery pack 110 as a power supply device, an inverter 140 connected to the battery pack 110, an on board charger (OBC) 142, and a low voltage DC-DC converter (LDC) 144. Herein, the inverter 140 may be a device for converting direct current electric energy supplied from the battery pack 110 into alternating current electric energy, the OBC 142 may be a device for charging the battery pack 110, and the LDC 144 may be a device for converting high voltage into low voltage to supply the voltage to a load included in the electric vehicle 100.

The battery pack 110 may include battery units 111, 112, and 113, and a BMS 120. Herein, each of the battery units 111, 112, and 113 may be a battery cell or a battery module. While three battery units (the first battery unit 111 to the $n^{th}$ battery unit 113) are shown in FIG. 1B, the present disclosure is not limited thereto, in which n is a natural number of 1 or greater.

The BMS 120 may include the battery performance diagnosis apparatus 20. The battery performance diagnosis apparatus 20 may diagnose whether each of the battery units 111, 112, and 113 is abnormal.

Operations performed in the battery performance diagnosis apparatus 20 may be performed not only in the BMS 120 shown in FIG. 1B, but also in various devices such as a server, a cloud, a charger, a charger/discharger, etc.

FIG. 2 is a block diagram showing the diagnosis module 220 of the battery performance diagnosis apparatus 20 according to an embodiment disclosed herein. Description of the diagnosis module 220 described with reference to FIG. 2 may also be applied to the first channel diagnosis module 230.

The diagnosis module 220 may include the information obtaining module 222, the pre-processing module 224, the diagnosis function executing module 226, the returning module 228, or a combination thereof.

During charging or discharging of the battery 40 by using the charger/discharger 10, the information obtaining module 222 may obtain the measurement information regarding the battery 40 in real time through the interface module 220. Herein, the measurement information may include a measurement signal and/or a state value. The measurement signal may include a voltage, a current, and/or a temperature, and the state value may include a SoH and/or an SoC.

The pre-processing module 224 may convert the measurement information into commands (e.g., DiagAICV(), DiagRoCV(), DiagSMAVD(), DiagCaSD(), DiagRdV(), DiafACAR()) respectively corresponding to one or more diagnosis functions. The diagnosis function executing module 226 may execute at least one diagnosis function based on the converted commands. Herein, a diagnosis function may be implemented through a library file (e.g., a dynamic link library (DLL) file) including diagnosis logic. The DLL file may be a file including instructions that may be called by a program to perform a specific task.

The diagnosis function executing module 226 may diagnose performance of the battery 40 by executing at least one diagnosis function among one or more diagnosis functions.

The diagnosis function executing module 226 may diagnose abnormal I CV (AICV), rising of CV current (RoCV), single moving average voltage deviation (SMAVD), capacity sudden drop (CaSD), relaxation deviation voltage (RdV), and accumulated capacity reduction (ACAR) through the one or more diagnosis functions.

In an embodiment, the diagnosis function executing module 226 may diagnose AICV through DiagAICV(). Herein, the AICV may indicate a state of the battery 40 in which a current does not decrease during a preset time in a constant voltage (CV) charging period of the battery 40. Herein, the preset time may be set at random by a setter. For example, the preset time may be 10 seconds.

In an embodiment, the diagnosis function executing module 226 may diagnose RoCV through DiagRoCV(). Herein, RoCV may indicate a state where at least one battery cell included in the battery 40 is short-circuited.

In an embodiment, the diagnosis function executing module 226 may diagnose SMAVD through DiagSMAVD(). Herein, SMAVD may indicate that a voltage of the battery 40 is abnormal.

In an embodiment, the diagnosis function executing module 226 may diagnose CaSD through DiagCaSD(). Herein, CaSD may indicate a fracture or short-circuit inside the battery 40. For example, the diagnosis function executing module 226 may determine whether the battery 40 indicates CaSD, based on a change of a charging capacity each time when charging of the battery 40 is completed.

In an embodiment, the diagnosis function executing module 226 may diagnose RdV through DiagRdV(). Herein, RdV may indicate that there is a cell having a short-circuit occurred among cells of the battery 40. For example, the diagnosis function executing module 226 may determine whether at least one battery cell among the cells of the battery indicate RdV, based on a coulombic efficiency.

In an embodiment, the diagnosis function executing module 226 may diagnose ACAR through DiagACAR(). Herein, ACAR may indicate that lithium precipitation or micro-short-circuit occurs inside the battery 40. For example, the diagnosis function executing module 226 may determine whether the battery 40 indicates ACAR, based on a change of a charging/discharging capacity difference of the battery while performing a charging/discharging cycle for the battery 40.

The diagnosis function executing module 226 may obtain a diagnosis result with respect to performance of the battery 40 based on at least one diagnosis function.

The diagnosis function executing module 226 may transmit the diagnosis result to the returning module 228.

The returning module 228 may receive the diagnosis result. The returning module 228 may receive the diagnosis result from the diagnosis function executing module 226.

The returning module 228 may transmit the diagnosis result to the interface module 210.

The interface module 210 may transmit the diagnosis result to the diagnosis controller 200.

The diagnosis controller 200 may receive the diagnosis result. The diagnosis controller 200 may receive the diagnosis result through the interface module 210.

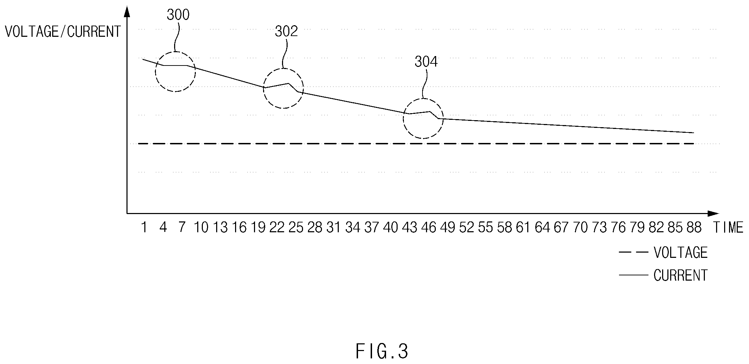

FIG. 3 is a graph showing a voltage and a current of the battery 40 over time according to an embodiment disclosed herein.

Referring to FIG. 3, the diagnosis function executing module 224 may diagnose performance of the battery 40 by executing a diagnosis function with respect to AICV. As a result of diagnosing performance of the battery 40, it may be seen that a battery cell corresponding to three periods 300, 302, and 304 is abnormal. In this case, the diagnosis function executing module 224 may obtain a diagnosis result indicating that the battery 40 is abnormal.

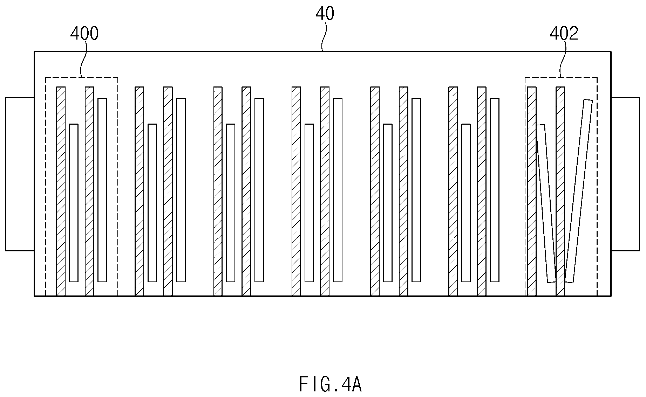

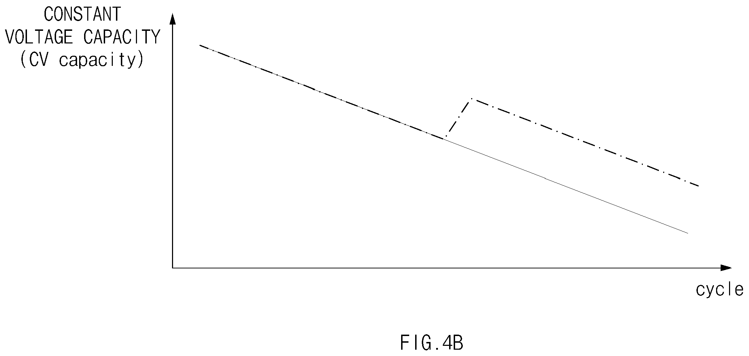

FIG. 4A shows the battery 40 including a short-circuited battery cell 402 according to an embodiment disclosed herein. FIG. 4B is a graph showing a diagnosis result according to an embodiment disclosed herein.

The diagnosis function executing module 224 may diagnose performance of the battery 40 by executing a diagnosis function with respect to RoCV.

Referring to FIG. 4A, the battery 40 may include a plurality of battery cells. A constant voltage capacity of the normal battery cell 400 continuously decreases, whereas a constant voltage capacity of the short-circuited battery cell 402 increases.

Referring to FIG. 4B, it may be seen that a constant voltage capacity sharply rises in a period 410 where a short-circuit occurs. When a rise of the constant voltage capacity is greater than a preset threshold value, the diagnosis function executing module 224 may obtain a diagnosis result indicating that the battery 40 is abnormal. The preset threshold value may be expressed as Equation 1.

[Equation 1]

$$Preset\ Threshold = CV\ Ah + \frac{CV\ Ah}{num(monocell)} \times 2$$

Herein, CV Ah may mean an accumulative current (unit: Ah) per cycle.

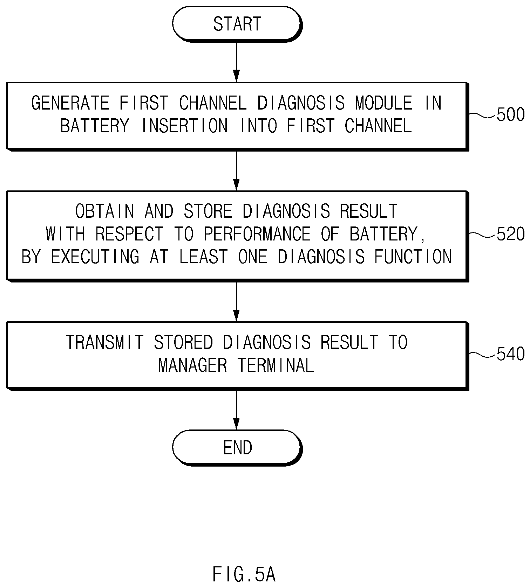

FIG. 5A is a flowchart of a battery performance diagnosis method according to an embodiment disclosed herein.

Referring to FIG. 5A, in operation 500, when the battery 40 is inserted into the first channel 13, the battery performance diagnosis apparatus 20 may generate the first channel diagnosis module 230. More specifically, the interface module 210 of the battery performance diagnosis apparatus 20 may generate the first channel diagnosis module 230, based on generation command of the diagnosis controller 200.

In operation 520, The diagnosis function executing module 226 may diagnose performance of the battery 40 by executing at least one diagnosis function among one or more diagnosis functions. The battery diagnosis apparatus 20 may obtain and store the diagnosis result.

More specifically, the diagnosis function executing module 226 of the battery performance diagnosis apparatus 20 may diagnose performance of the battery 40 by executing at least one diagnosis function among one or more diagnosis functions. The diagnosis function executing module 226 may obtain the diagnosis result of diagnosing performance of the battery 40.

The diagnosis function executing module 226 may transmit the diagnosis result to the returning module 228.

The returning module 228 may return the diagnosis result to the diagnosis controller 200.

The diagnosis controller 200 may store the diagnosis result.

In operation 540, the battery performance diagnosis apparatus 20 may transmit the stored diagnosis result to the manager terminal 30.

More specifically, the diagnosis controller 200 of the battery performance diagnosis apparatus 20 may transmit the stored diagnosis result to the transmitting unit 260. The transmitting unit 260 may transmit the received diagnosis result to the manager terminal 30. Herein, the diagnosis result may include a result corresponding battery performance diagnosis of operation 520.

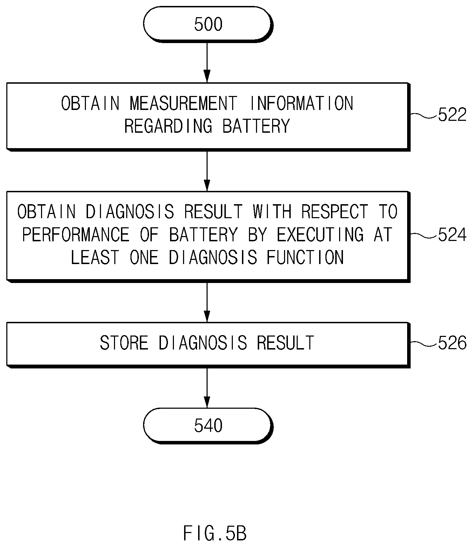

FIG. 5B is a flowchart of a method for executing a diagnosis function according to an embodiment disclosed herein.

Operations 522, 524, and 526 of FIG. 5B may be included in operation 520 of FIG. 5A. Herein, it is assumed that the first channel diagnosis module 230 is generated by operation 500 of FIG. 5A. The first channel diagnosis module 230 may include the information obtaining module 222, the diagnosis function executing module 226, the returning module 228, or a combination thereof.

In operation 522, the battery performance diagnosis apparatus 20 may obtain the measurement information. More specifically, the information obtaining module 222 of the battery performance diagnosis apparatus 20 may obtain the measurement information including the measurement signal and/or the state value of the battery 40.

In operation 524, The diagnosis function executing module 20 may generate the diagnosis result with respect to performance of the battery 40 by executing at least one diagnosis function among one or more diagnosis functions.

More specifically, the diagnosis function executing module 224 of the battery performance diagnosis apparatus 20 may diagnose performance of the battery 40 based on the measurement information by executing at least one diagnosis function among one or more diagnosis functions.

In operation 526, the battery performance diagnosis apparatus 20 may store the diagnosis result.

More specifically, the returning module 228 of the battery performance diagnosis apparatus 20 may transmit the diagnosis result to the diagnosis controller 200.

The diagnosis controller 200 may store the received diagnosis result.

After operation 526, operation 540 may be performed.

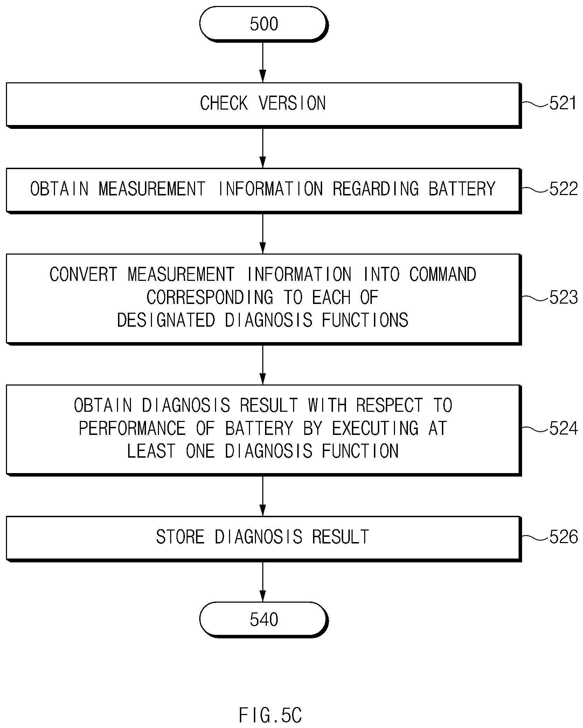

FIG. 5C is a flowchart of a method for executing a diagnosis function according to an embodiment disclosed herein.

Operations 521, 522, 523, 524, and 526 of FIG. 5C may be included in operation 520 of FIG. 5A. Herein, it is assumed that the first channel diagnosis module 230 is generated by operation 500 of FIG. 5A. The first channel diagnosis module 230 may include the information obtaining module 222, the pre-processing module 224, the diagnosis function executing module 226, the returning module 228, or a combination thereof.

In operation 521, the battery performance diagnosis apparatus 20 may check a version. The battery performance diagnosis apparatus 20 may check the version of the diagnosis module 220 and the version of the first channel diagnosis module 230.

More specifically, the diagnosis controller 200 of the battery performance diagnosis apparatus 20 may transmit the version check command (Init()) to the interface module 210.

The interface module 210 may load the version checking module 240 into the memory, based on the version check command (Init()).

The interface module 210 may convert the version check command (Init()) into the version check command (CheckVersion()) and transmit the same to the version checking module 230.

The version checking module 230 may compare a version of the diagnosis module 220 with a version of the first channel diagnosis module 230. Upon receiving the converted version check command (CheckVersion()) from the interface module 210, the version checking module 230 may compare the version of the diagnosis module 220 with the version of the first channel diagnosis module 230.

When the version check is completed, operation 522 may be performed.

In operation 523, the battery performance diagnosis apparatus 20 may convert the measurement information into a command corresponding to each of designated diagnosis functions. More specifically, the pre-processing module 224 may convert the measurement information into a command corresponding to each of one or more diagnosis functions. The diagnosis function executing module 226 may execute at least one diagnosis function among the one or more diagnosis functions, based on the converted command.

After operation 523, operations 524, 526, and 540 may be performed.

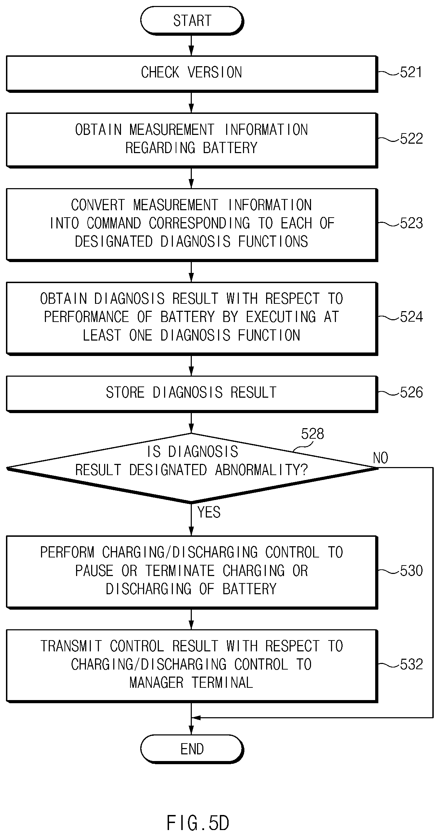

FIG. 5D is a flowchart of a method for executing a diagnosis function according to an embodiment disclosed herein.

Operations 521, 522, 523, 524, 526, 528, 530, and 532 of FIG. 5D may be included in operation 520 of FIG. 5A. Herein, it is assumed that the first channel diagnosis module 230 is generated by operation 500 of FIG. 5A. The diagnosis module 220 may include the information obtaining module 222, the pre-processing module 224, the diagnosis function executing module 226, the returning module 228, or a combination thereof.

After operations 521 to 526 described above are performed, the charging/discharging controller 250 may determine whether the diagnosis result indicates designated abnormality, in operation 528.

When it is determined that the diagnosis result indicates the designated abnormality, the charging/discharging controller 250 may perform charging/discharging control to pause or terminate charging or discharging, in operation 530.

When it is determined that the diagnosis result does not indicate the designated abnormality, operation 540 may be performed.

When control for pause or termination is performed, the transmitting unit 260 may transmit a charging/discharging control result to the manager terminal 30, in operation 532.

More specifically, the transmitting unit 260 may transmit the charging/discharging control result, received from the charging/discharging controller 250, to the manager terminal 30.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

**Claims**

1. A battery performance diagnosis apparatus comprising:

   a diagnosis module;
   a diagnosis controller configured to generate a generation command instructing generation of a first channel diagnosis module for a first channel among a plurality of channels of a charger/discharger, based on the diagnosis module, when a battery is inserted into the first channel; and
   an interface module configured to copy the diagnosis module and load the first channel diagnosis module, based on the generation command,
   wherein the first channel diagnosis module comprises:

   an information obtaining module configured to obtain measurement information regarding the battery in real time through the interface module, during charging or discharging of the battery by using the charger/-discharger;
   a diagnosis function executing module configured to, by executing at least one diagnosis function among one or more diagnosis functions, diagnose performance of the battery based on the measurement information and obtain a diagnosis result with respect to the at least one diagnosis function; and
   a returning module configured to return the diagnosis result to the diagnosis controller, through the interface module,
   wherein the diagnosis controller is further configured to store the diagnosis result and generate a termination command instructing termination of the first channel diagnosis module, when charging or discharging of the battery is completed.

2. The battery performance diagnosis apparatus of claim 1, further comprising a transmitting unit configured to transmit the diagnosis result to a manager terminal.

3. The battery performance diagnosis apparatus of claim 2, further comprising a charging/discharging controller configured to control the charger/discharger to pause or terminate charging or discharging of the battery, when the diagnosis result indicates designated abnormality of the battery or the charger/discharger.

4. The battery performance diagnosis apparatus of claim 3, wherein the transmitting unit is further configured to transmit a charging/discharging control result regarding the pause or termination to the manger terminal, when charging or discharging is paused or terminated.

5. The battery performance diagnosis apparatus of claim 1, further comprising a version checking module loaded to a memory by the interface module to compare a version of the diagnosis module with a version of the first channel diagnosis module, based on a version check command generated by the diagnosis controller.

**EP 4 592 694 A1**

6. The battery performance diagnosis apparatus of claim 1, wherein the diagnosis function executing module is further configured to generate a diagnosis result indicating abnormality of the battery or abnormality of the charger/discharger when a measured current of the battery does not decrease for a preset time or more in a constant voltage charging period of the battery, as a first diagnosis function among the one or more diagnosis functions.

7. The battery performance diagnosis apparatus of claim 1, wherein the first channel diagnosis module further comprises a pre-processing module configured to convert the measurement information into a command corresponding to each of the one or more diagnosis functions, and the diagnosis function executing module is further configured to execute each of the one or more diagnosis functions based on the converted command.

8. A battery performance diagnosis method comprising:

a diagnosis control operation of generating a generation command instructing generation of a first channel diagnosis module for a first channel among a plurality of channels of a charger/discharger, based on a diagnosis module comprising one or more diagnosis functions, when a battery is inserted into the first channel;
an interface operation of loading the first channel diagnosis module, based on the generation command; and
an operation of diagnosing performance of the battery based on the first channel diagnosis module,
wherein the diagnosing of the performance of the battery comprises:

an information obtaining operation of obtaining measurement information regarding the battery in real time, during charging or discharging of the battery by using the charger/discharger;
a diagnosis function executing operation of diagnosing the battery based on the measurement information by executing at least one diagnosis function among the one or more diagnosis functions;
an operation of obtaining a diagnosis result with respect to the at least one diagnosis function among the one or more diagnosis functions; and
an operation of storing the diagnosis result,
wherein a termination command instructing termination of the first channel diagnosis module is generated, when charging or discharging of the battery is completed.

9. The battery performance diagnosis method of claim 8, further comprising an operation of transmitting the diagnosis result to a manager terminal.

10. The battery performance diagnosis method of claim 9, further comprising a charging/discharging control operation of performing control to pause or terminate charging or discharging of the battery, when the diagnosis result indicates designated abnormality of the battery or the charger/discharger.

11. The battery performance diagnosis method of claim 10, further comprising an operation of transmitting a charging/-discharging control result regarding the pause or termination to the manger terminal, when charging or discharging is paused or terminated.

12. The battery performance diagnosis method of claim 8, further comprising:

an operation of generating a version check command;
an operation of loading a version check module into a memory based on the version check command; and
an operation of comparing a version of the diagnosis module with a version of the first channel diagnosis module, by using the version check module.

13. The battery performance diagnosis method of claim 8, wherein the diagnosis function executing operation comprises an operation of obtaining a diagnosis result indicating abnormality of the battery or abnormality of the charger/-discharger when a measured current of the battery does not decrease for a preset time or more in a constant voltage charging period of the battery, as a first diagnosis function among the one or more diagnosis functions.

14. The battery performance diagnosis method of claim 8, further comprising a pre-processing operation of converting the measurement information into a command corresponding to each of the one or more diagnosis functions, wherein the diagnosis function executing operation is performed for the one or more diagnosis functions based on the converted command.

12

FIG. 1A

EP 4 592 694 A1

100

BATTERY PACK
110

FIRST BATTERY UNIT
111

SECOND BATTERY UNIT
112

N^{TH} BATTERY UNIT
113

BMS
120

BATTERY PERFORMANCE
DIAGNOSIS APPARATUS
20

INVERTER
140

OBC
142

LDC
144

FIG.1B

220

| INFORMATION OBTAINING MODULE | ~222 |

| PRE-PROCESSING MODULE | ~224 |

| DIAGNOSIS FUNCTION EXECUTING MODULE | ~226 |

| RETURNING MODULE | ~228 |

FIG.2

FIG.3

FIG.4A

CONSTANT
VOLTAGE CAPACITY
(CV capacity)

cycle

FIG.4B

START

GENERATE FIRST CHANNEL DIAGNOSIS MODULE IN BATTERY INSERTION INTO FIRST CHANNEL ~500

OBTAIN AND STORE DIAGNOSIS RESULT WITH RESPECT TO PERFORMANCE OF BATTERY, BY EXECUTING AT LEAST ONE DIAGNOSIS FUNCTION ~520

TRANSMIT STORED DIAGNOSIS RESULT TO MANAGER TERMINAL ~540

END

FIG.5A

```
               ┌─────────┐
               │   500   │
               └────┬────┘
                    │
                    ▼
    ┌───────────────────────────────────┐
    │   OBTAIN MEASUREMENT INFORMATION   │──── 522
    │        REGARDING BATTERY           │
    └────────────────┬──────────────────┘
                     │
                     ▼
    ┌───────────────────────────────────┐
    │  OBTAIN DIAGNOSIS RESULT WITH RESPECT TO │
    │  PERFORMANCE OF BATTERY BY EXECUTING AT  │──── 524
    │     LEAST ONE DIAGNOSIS FUNCTION         │
    └────────────────┬──────────────────┘
                     │
                     ▼
    ┌───────────────────────────────────┐
    │        STORE DIAGNOSIS RESULT      │──── 526
    └────────────────┬──────────────────┘
                     │
                     ▼
               ┌─────────┐
               │   540   │
               └─────────┘
```

FIG.5B

```
                        ┌─────────┐
                        │   500   │
                        └────┬────┘
                             │
                             ▼
    ┌────────────────────────────────────────────────────┐
    │                  CHECK VERSION                       │──521
    └────────────────────────┬───────────────────────────┘
                             │
                             ▼
    ┌────────────────────────────────────────────────────┐
    │   OBTAIN MEASUREMENT INFORMATION REGARDING BATTERY  │──522
    └────────────────────────┬───────────────────────────┘
                             │
                             ▼
    ┌────────────────────────────────────────────────────┐
    │     CONVERT MEASUREMENT INFORMATION INTO COMMAND     │
    │            CORRESPONDING TO EACH OF                  │──523
    │         DESIGNATED DIAGNOSIS FUNCTIONS              │
    └────────────────────────┬───────────────────────────┘
                             │
                             ▼
    ┌────────────────────────────────────────────────────┐
    │      OBTAIN DIAGNOSIS RESULT WITH RESPECT TO         │
    │    PERFORMANCE OF BATTERY BY EXECUTING AT           │──524
    │        LEAST ONE DIAGNOSIS FUNCTION                 │
    └────────────────────────┬───────────────────────────┘
                             │
                             ▼
    ┌────────────────────────────────────────────────────┐
    │                STORE DIAGNOSIS RESULT               │──526
    └────────────────────────┬───────────────────────────┘
                             │
                             ▼
                        ┌─────────┐
                        │   540   │
                        └─────────┘
```

FIG.5C

START

CHECK VERSION ～521

OBTAIN MEASUREMENT INFORMATION
REGARDING BATTERY ～522

CONVERT MEASUREMENT INFORMATION
INTO COMMAND CORRESPONDING TO EACH OF
DESIGNATED DIAGNOSIS FUNCTIONS ～523

OBTAIN DIAGNOSIS RESULT WITH RESPECT TO
PERFORMANCE OF BATTERY BY EXECUTING AT
LEAST ONE DIAGNOSIS FUNCTION ～524

STORE DIAGNOSIS RESULT ～526

IS DIAGNOSIS
RESULT DESIGNATED ABNORMALITY? 528 NO

YES

PERFORM CHARGING/DISCHARGING CONTROL TO
PAUSE OR TERMINATE CHARGING OR
DISCHARGING OF BATTERY ～530

TRANSMIT CONTROL RESULT WITH RESPECT TO
CHARGING/DISCHARGING CONTROL TO
MANAGER TERMINAL ～532

END

FIG.5D

# EP 4 592 694 A1

<table>
<tr><td colspan="2" align="center">INTERNATIONAL SEARCH REPORT</td><td>International application No.<br><br>**PCT/KR2023/017347**</td></tr>
</table>

**A.    CLASSIFICATION OF SUBJECT MATTER**

**G01R 31/367**(2019.01)i; **G01R 31/371**(2019.01)i; **G01R 31/396**(2019.01)i; **G01R 31/3842**(2019.01)i; **G01R 19/165**(2006.01)i

According to International Patent Classification (IPC) or to both national classification and IPC

**B.    FIELDS SEARCHED**

Minimum documentation searched (classification system followed by classification symbols)

G01R 31/367(2019.01); G01R 19/165(2006.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충방전(charging-discharging), 채널(channel), 진단(diagnosis), 인터페이스 모듈(interface module)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2012-0090425 A (HAN, Chan-Hee) 17 August 2012 (2012-08-17)<br>See paragraphs [0001]-[0060]; and figure 1. | 1-14 |
| A | KR 10-2019-0118295 A (ECOPOWERTECH CO., LTD.) 18 October 2019 (2019-10-18)<br>See paragraphs [0001]-[0041]; and figures 1-6. | 1-14 |
| A | KR 10-2022-0036701 A (LG ENERGY SOLUTION, LTD.) 23 March 2022 (2022-03-23)<br>See paragraphs [0032]-[0092]; and figures 1-3. | 1-14 |
| A | KR 10-1377995 B1 (POWER SOLUTION) 25 March 2014 (2014-03-25)<br>See paragraphs [0009]-[0043]; and figures 1-2. | 1-14 |
| A | KR 10-2011-0077194 A (OH, Hyun-Taek et al.) 07 July 2011 (2011-07-07)<br>See paragraphs [0001]-[0039]; and figures 1-4. | 1-14 |

☐ Further documents are listed in the continuation of Box C.          ☑ See patent family annex.

| | | |
|---|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "D"    document cited by the applicant in the international application | "X"    document of particular relevance; the claimed invention cannot be considered novel or cannot be considered to involve an inventive step when the document is taken alone |
| "E"    earlier application or patent but published on or after the international filing date | |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **07 February 2024** | **07 February 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/017347**

| Patent document cited in search report | | | Publication date (day/month/year) | Patent family member(s) | | | Publication date (day/month/year) |
|---|---|---|---|---|---|---|---|
| KR | 10-2012-0090425 | A | 17 August 2012 | KR | 10-1202165 | B1 | 15 November 2012 |
| KR | 10-2019-0118295 | A | 18 October 2019 | None | | | |
| KR | 10-2022-0036701 | A | 23 March 2022 | None | | | |
| KR | 10-1377995 | B1 | 25 March 2014 | None | | | |
| KR | 10-2011-0077194 | A | 07 July 2011 | KR | 10-1210523 | B1 | 10 December 2012 |

Form PCT/ISA/210 (patent family annex) (July 2022)

**EP 4 592 694 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020220149084
- KR 1020230148282